(19) Europäisches Patentamt
European Patent Office
Office européen des brevets

(11) EP 0 657 745 B1

(12) **FASCICULE DE BREVET EUROPEEN**

(45) Date de publication et mention
de la délivrance du brevet:
**17.10.2001 Bulletin 2001/42**

(51) Int Cl.$^7$: **G01R 31/36**, G08C 15/12

(21) Numéro de dépôt: **94402803.4**

(22) Date de dépôt: **06.12.1994**

(54) **Circuit de mesure pour ensemble modulaire de cellules électriquement montées en série, notamment pour batterie d'accumulateur électrique**

Messschaltung für eine modulare Anordnung elektrisch in Serie geschalteter Zellen, insbesondere für eine elektrische Akkumulatorbatterie

Measuring circuit for modular assembly of electrically series connected cells, especially for electric accumulator battery

(84) Etats contractants désignés:
**CH DE ES FR GB IT LI SE**

(30) Priorité: **09.12.1993 FR 9314798**

(43) Date de publication de la demande:
**14.06.1995 Bulletin 1995/24**

(73) Titulaire: **ALCATEL**
**75008 Paris (FR)**

(72) Inventeur: **Perelle, Michel**
**F-37210 Parcay-Meslay (FR)**

(74) Mandataire: **Laroche, Danièle et al**
**COMPAGNIE FINANCIERE ALCATEL**
**Dépt. Propriété Industrielle,**
**30, avenue Kléber**
**75116 Paris (FR)**

(56) Documents cités:
**EP-A- 0 112 242**       **EP-A- 0 277 321**
**US-A- 5 099 211**

• **RESEARCH DISCLOSURE, no.344, Décembre 1992, HAVANT GB pages 929 - 930 'A Voltage Monitoring System ... Multi-Cell ... Daisy-Chained Serial ... At Each Node'**

Printed by Jouve, 75001 PARIS (FR)

## Description

L'invention concerne un circuit de mesure pour ensemble modulaire de cellules électriquement montées en série. L'exploitation de certains ensembles électriques modulaires composés de cellules électriquement montés en série est susceptible d'être nettement optimisée, notamment lorsque le nombre des cellules est relativement grand, s'il est possible de contrôler facilement le fonctionnement de chacune des cellules et par conséquent s'il est possible d'effectuer des mesures par cellule ou à défaut par petit groupe de cellules pour un même ensemble. Tel peut être le cas par exemple pour des ensembles modulaires respectivement de type batterie d'accumulateur, supercondensateur, superconvertisseur ou autre qui sont individuellement et modulairement composés de cellules dont on peut souhaiter contrôler le fonctionnement individuel.

Or la réalisation d'un circuit apte à réaliser de telles mesures, par exemple des mesures de tension électrique cellule par cellule, qui peut paraître simple en son principe se complique, en fait, dès que le nombre de d'éléments devient grand. Le nombre élevé de fils de mesure alors impliqués conduit généralement à des réalisations relativement lourdes impliquant la mise en place de moyens de commutation nécessitant un nombre élevé d'unités commutantes qui, notamment si ces moyens sont de type électromagnétique, ont conduit à ce que ces circuits ne soient que peu exploités, et seulement le plus souvent pour des réalisations particulières où ils sont pratiquement inévitables.

Un document US-A-5168273 divulgue un système pour collecter des données provenant de dispositifs montés en série de manière qu'initialement seul le dispositif qui est le plus proche d'une unité de commande, soit énergisé, les autres dispositifs étant séquentiellement commutés dès que le dispositif précédent a été énergisé.

Un document EP-A-0277321 divulgue un agencement associant un analyseur à des circuits de mesure affectés à des cellules d'une batterie multicellulaire. L'analyseur comporte un contrôleur qui produit un signal de démarrage qui est appliqué aux circuits de mesure pour les activer l'un après l'autre.

L'invention propose un circuit de mesure pour ensemble modulaire de cellules électriquement montées en série et constituées chacune d'un ou de plusieurs éléments producteurs, accumulateurs ou convertisseurs d'énergie électrique, notamment d'éléments de batterie d'accumulateur électrique.

Le circuit de mesure comprend des interfaces de mesure individuelles respectivement connectées chacune aux bornes d'énergie d'une cellule différente et comportant chacune une sortie de mesure monofilaire pour un signal de mesure en courant destiné à être transmis vers un transducteur commun auquel les sorties de mesure respectives des interfaces sont communément reliées, via une première liaison monofilaire commune, dans le circuit de mesure considéré. Chaque interface incorpore au moins un premier générateur de courant pour produire un signal de mesure en courant relatif à une caractéristique évolutive de la cellule correspondante et un circuit de commande pour prendre en compte une des impulsions de commande, qui sont transmises en série dans le cadre d'un train par l'intermédiaire d'une seconde liaison monofilaire afin de commuter les générateurs de courant de mesure des interfaces successivement passants.

Selon une caractéristique de l'invention, le circuit de mesure le circuit de commande de chaque interface est agencé pour prendre en compte la première impulsion de commande d'un train que l'interface reçoit d'un élément de seconde liaison monofilaire, via une première entrée, et pour transmettre toute éventuelle impulsion suivante de ce même train, vers l'éventuelle interface située en aval dont la première entrée est alors reliée à sa propre sortie par un autre des éléments successifs constituant la seconde liaison monofilaire.

L'invention, ses caractéristiques et ses avantages sont précisés dans la description qui suit en liaison avec les figures évoquées ci-dessous.

La figure 1 présente un schéma de principe d'un circuit de mesure selon l'invention.

La figure 2 présente un chronogramme relatif au mode de fonctionnement d'un circuit de mesure, selon l'invention. La figure 3 présente le schéma électrique d'un exemple de réalisation d'une interface individuelle de cellule pour circuit de mesure selon l'invention. La figure 4 présente un schéma d'une variante relative à une partie du circuit proposé en figure 3.

La figure 5 présente un chronogramme relatif au fonctionnement des circuits présentés sur les figures 3, 4.

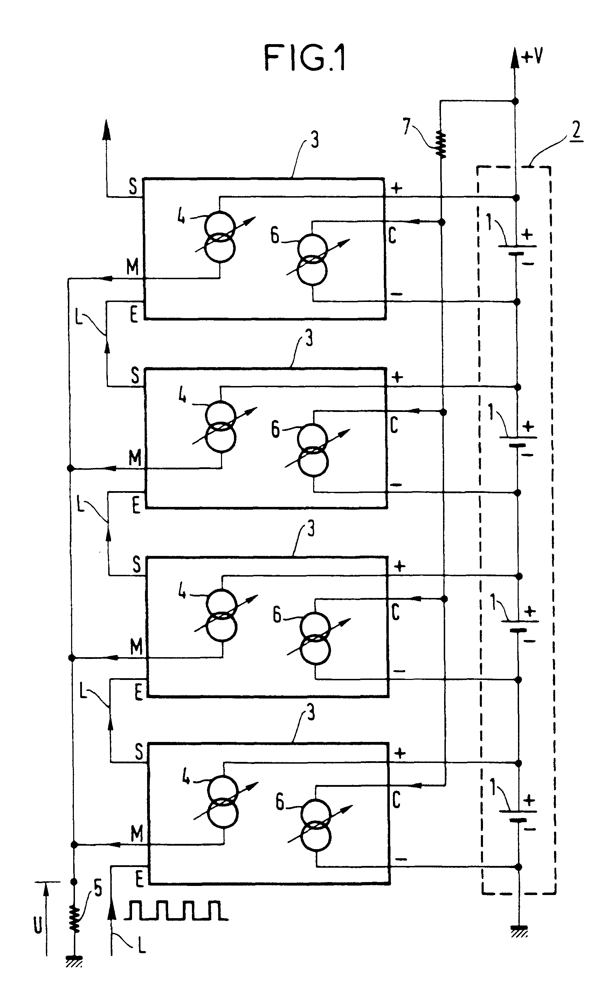

Comme symbolisé en figure 1, le circuit de mesure selon l'invention est destiné à être associé à un ensemble électrique modulaire composé d'une pluralité de cellules 1 connectées en série au niveau des bornes de transmission d'énergie qu'elles comportent chaque cellule étant classiquement supposée disposant de deux bornes référencées "+" et "-". L'ensemble 2 est supposé constitué par des cellules 1 composées chacune d'un ou de plusieurs éléments qui sont par exemple producteurs, accumulateurs ou convertisseurs d'énergie électrique et le circuit de mesure est destiné à permettre de collecter des informations relatives au fonctionnement des cellules, en particulier au niveau individuel.

Le circuit de mesure schématisé en figure 1 est ici supposé destiné à déterminer, à titre principal, la valeur de la tension continue présente aux bornes de chacune des cellules 1 d'un ensemble électrique modulaire 2 constitué par des éléments ou blocs d'éléments d'une alimentation électrique de type batterie d'accumulateur. Les cellules de l'ensemble sont connectées en série dans cet ensemble au niveau de leurs bornes de transmission d'énergie, chaque cellule étant identiquement constituée d'un ou de plusieurs éléments et comportant deux bornes de transmission d'énergie "+" et "-" Selon l'invention, le circuit comporte des interfaces de mesure individuelles 3 pour chacune des cellules 1 de l'ensemble 2 auquel il est associé. Chaque interface 3 est reliée aux bornes de transmission d'énergie "+" et "-" de l'une des cellules et comporte un générateur de courant 4, commutable, ici montré inséré entre la borne "+" de la cellule 1 à laquelle il est associé et une borne d'un transducteur 5. Ce transducteur 5, constitué par exemple par une résistance, est chargé de transformer le courant fourni par un générateur de courant 4 d'une interface 3, via un seul fil, en une tension U image de la grandeur mesurée au niveau de cette interface, telle ici la tension présente aux bornes de la cellule à laquelle l'interface considérée est affectée, lorsque ce générateur de courant est commandé passant.

Dans la réalisation proposée, le transducteur 5 est commun à toutes les interfaces individuelles 3 du circuit de mesure, étant identiquement relié par une de ses deux bornes à un potentiel de masse commun au circuit de mesure et à l'ensemble formé par les cellules 1 en série et par l'autre de ses bornes à une sortie de mesure M individuelle monofilaire de chacun des générateurs de courant 4, respectifs, des interfaces 3, via une liaison monofilaire commune.

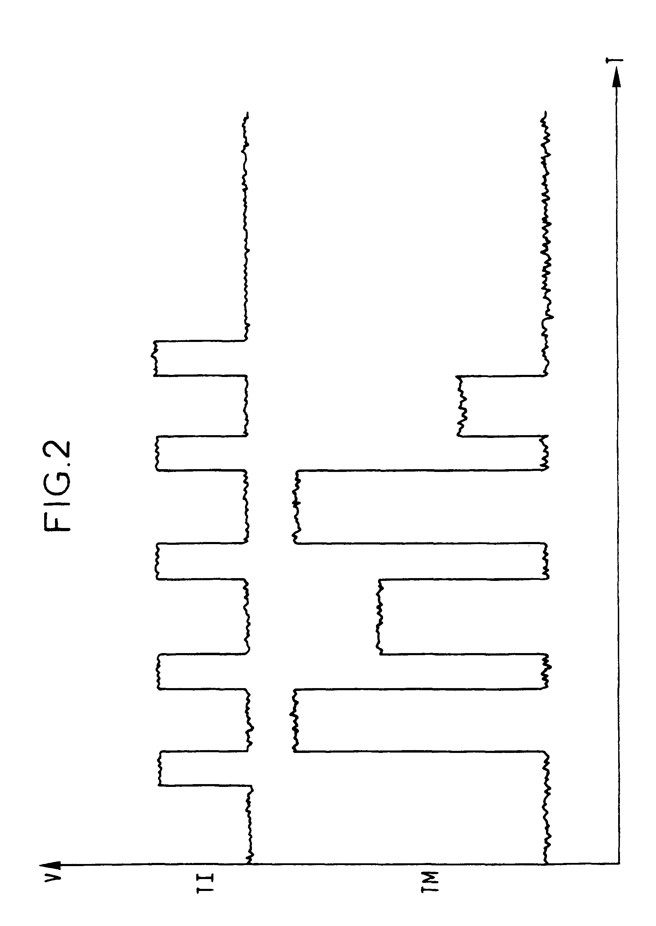

La commutation de chaque générateur de courant 4 est par exemple obtenue sous l'action d'une impulsion de commande qui est ici supposée transmise dans le cadre d'un train d'impulsions de commande TI où chaque impulsion est supposée destinée à une interface déterminée de la suite des interfaces 3 du circuit de mesure supposées reliées entre elles en série. Un train d'impulsions de commande TI, tel que montré en figure 2, est supposé envoyé par des moyens générateurs, de type usuel, d'une logique de supervision non représentée à l'entrée E de l'interface 3 desservant une cellule 1 considérée comme tête de série et placée à une des extrémités du groupe formé par les interfaces 3 en série, la cellule de tête étant ici celle dont la borne négative "-" est directement reliée à un potentiel de masse de l'ensemble 2.

Il est prévu que chaque interface prenne en compte pour elle-même la première impulsion d'un train de commande qu'elle reçoit et transmette les éventuelles impulsions suivantes de ce train vers l'interface, située en aval, dont l'entrée E est reliée à sa propre sortie S par un élément d'une liaison monofilaire morcelée référencée L.

Le générateur de courant 4 est commuté passant, d'une manière précisée plus loin, par l'impulsion d'un train de commande qui est prise en compte par l'interface 3 qui le comporte, il fournit alors un courant au transducteur 5 qui est fonction de la cellule 1 à laquelle est affectée l'interface considérée. Si le transducteur 5 est une résistance comme supposé plus haut, il apparaît donc une tension aux bornes de cette résistance qui est représentative de la tension présente entre les bornes de la cellule 1 alimentante. Chacune des impulsions successives d'un train de commande TI actionne temporairement le générateur de courant 4 d'une des interfaces dans l'ordre de succession de ces interfaces à partir de celle qui reçoit la première impulsion des trains. Ceci est symbolisé par la courbe TM de la figure 2 qui présente un exemple de relevé supposé réalisé à partir d'un train de commande TI constitué d'impulsions binaires périodiques. Ces impulsions ou, ici, plus précisément les paliers de valeur binaire zéro des impulsions d'un même train TI déclenchent successivement une mise à l'état passant du générateur de courant 4 de chacune des interfaces 3 raccordées aux cellules 1, à partir de celle de ces interfaces qui reçoit et conserve la première des impulsions des trains de commande, soit ici celle affectée à la cellule 1 directement reliée au potentiel de masse commun. Il s'ensuit l'apparition d'un train d'impulsions de tension TM, aux bornes de la résistance constituant le transducteur 5, où chaque impulsion, ici positive, est représentative de la tension présente entre bornes de la cellule alors mise en circuit avec cette résistance de transducteur par son générateur de courant 4, quatre valeurs différentes de tension étant ici figurées. Additionnellement, s'il est nécessaire que le courant ponctionné au niveau de chaque cellule de l'ensemble 2 au cours des mesures successives effectuées sous la commande d'un train d'impulsions soit équilibré, il est prévu d'associer un second générateur de courant 6, commutable, dans chaque interface 3 et un élément de compensation commun 7, correspondant au moins approximativement au transducteur 5, dans le circuit de mesure. Cet élément de compensation 7, par exemple de type résistance, est relié à la borne positive "+V" de l'ensemble 2 de cellules 1 ainsi qu'à chacun des seconds générateurs du circuit de mesure par une seconde borne. Chaque second générateur de courant 6 est supposé commuté par la même commande que le générateur de courant 4 associé à lui dans l'interface 3 qui les comporte, il est inséré entre l'élément de compensation 7 commun du circuit de mesure, auquel il est relié par une borne ici référencée C, et la borne "-" de la cellule 1 à laquelle l'interface 3 qui le comporte est affectée.

Ainsi la commande d'une interface 3, affectée à une cellule 1 entraîne un prélèvement d'énergie, éventuellement partagé, au profit du premier générateur de courant 4 de cette interface sur au moins cette cellule 1, ainsi que sur toute autre cellule 1 de l'ensemble 2 insérée entre le potentiel de masse et ladite cellule 1 à laquelle est affectée l'interface considérée. Simultanément un prélèvement d'énergie, lui aussi éventuellement partagé, est effectué au profit du second générateur de la même interface 3 sur au moins la cellule 1 à laquelle est affectée cette interface et sur toute autre cellule 1 de l'ensemble 2 insérée entre la borne positive "+V" de cet ensemble et ladite cellule 1 à laquelle est affectée l'interface considérée. Ceci conduit donc à une répartition équilibrée des prélèvements sur toutes les cellules de l'ensemble 2, à chaque série de mesures correspondant à un train complet d'impulsions de commande.

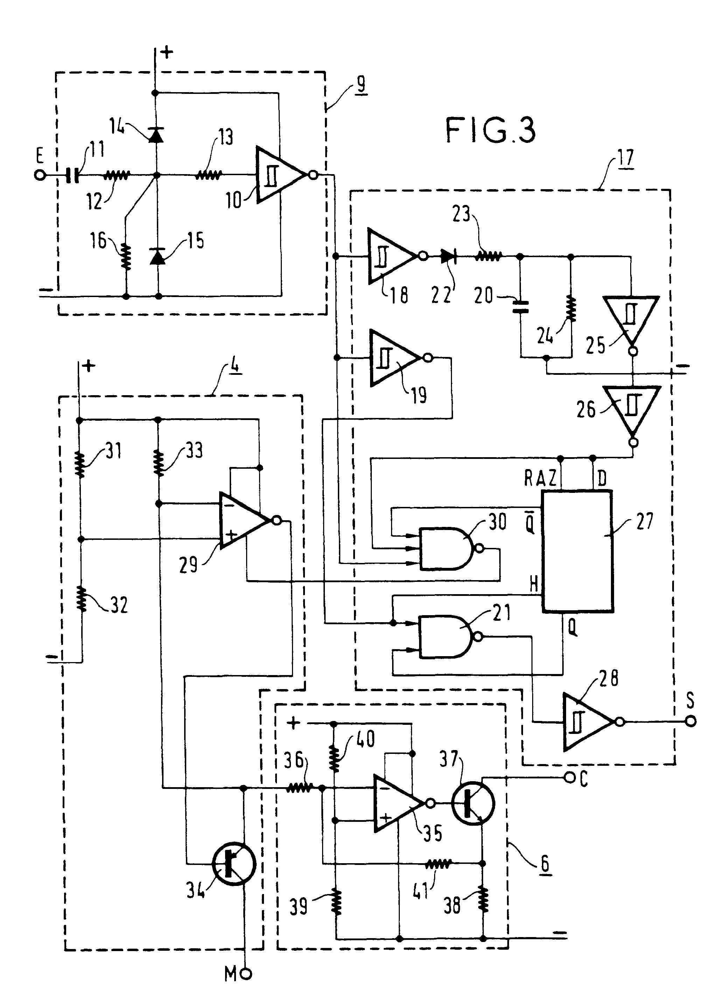

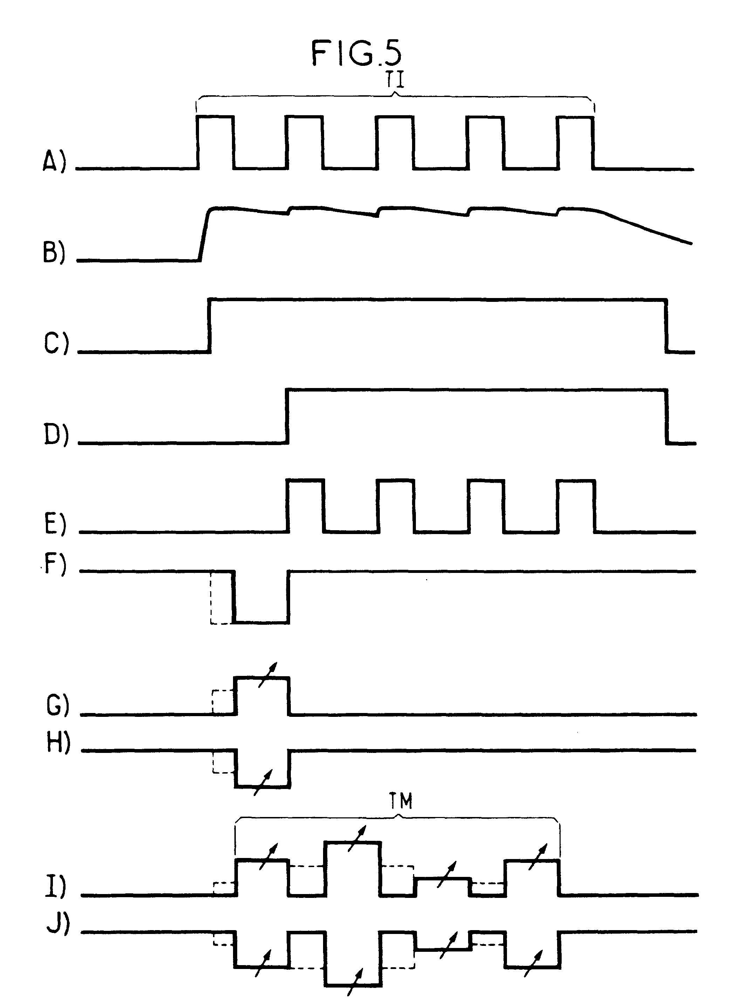

Un premier exemple de réalisation d'une interface de mesure individuelle de cellule pour circuit selon l'invention est présenté en figure 3. Cette interface 3 reçoit toute impulsion de commande qui lui est transmise par un élément de liaison monofilaire L aval au niveau d'une entrée E à laquelle est relié un circuit d'entrée 9 chargé de la remise en forme des impulsions reçues. Un train de commande prévu pour la réalisation de mesures sur un ensemble à quatre cellules est représenté à titre d'exemple par le diagramme A de la figure 5, il comporte à cet effet cinq impulsions identiques montrées ici, au moins approximativement, régulièrement espacées dans le temps.

Le circuit d'entrée 9 comporte une porte 10, constituée par un amplificateur inverseur à seuil, attaqué par les impulsions de commande au travers d'un condensateur 11 d'élimination de composante continue et de deux résistances 12 et 13 en série, cet amplificateur est ici alimenté entre la borne négative "-" et la borne positive "+" de la cellule à laquelle l'interface est raccordée. Deux diodes 14 et 15 montées en série entre ces bornes "-" et "+" de cellule associée sont également incluses dans ce circuit d'entrée où elles constituent un montage écrêteur où l'anode de la diode 12 et la cathode de la diode 13 sont reliées au point commun aux résistances 12 et 13. Une résistance 16, de forte valeur, en parallèle à la diode 15, fixe le potentiel en l'absence d'impulsion de commande et complète ce circuit d'entrée qui est destiné à transmettre les impulsions des trains de commande TI qu'il reçoit à un circuit de commande d'interface 17.

Ce dernier comporte deux portes 18 et 19, de type amplificateur inverseur à seuil, en parallèle en sortie de la porte 10 pour assurer une mise en phase du signal d'entrée qui est appliqué, d'une part, à un condensateur 20, via la porte 18 et, d'autre part, à une entrée d'une porte de contrôle d'accès 21, via la porte 19.

Le condensateur 20 a une borne reliée en sortie de porte 18 par une diode 22 et une résistance 23 en série et une seconde borne reliée à la borne "-" de la cellule associée, il se charge dès la première impulsion d'un train de commande TI et se maintient pratiquement chargé pour la durée du train comme le montre le diagramme B de la figure 5. Une résistance 24 montée en parallèle à ce condensateur 20 permet sa décharge à la fin d'un train.

Le point commun au condensateur 20 et aux résistances 23 et 24 est relié à l'entrée d'un premier de deux inverseurs logiques 25 et 26 montés en série en amont de l'entrée de données D d'une bascule 27, de type D, et de l'entrée de remise à zéro de cette bascule. En l'absence d'impulsion et par conséquent de charge au niveau du condensateur 20, la bascule 27 a son entrée de données D et son entrée de remise à zéro RAZ maintenues à zéro. L'apparition d'un train d'impulsions TI au niveau de l'entrée E entraîne l'apparition d'un créneau qui est retardé du temps de charge du condensateur 20 et dont la durée est en correspondance avec celle du train reçu en sortie de l'inverseur 26, comme on le voit sur le diagramme C de la figure 5. Il y a, en conséquence, application d'un signal de niveau logique 1 à l'entrée D de la bascule 27. L'entrée d'horloge H de la bascule 27 est reliée en sortie de la porte 19 et recopie donc en sortie Q le niveau logique présent à l'entrée D et le niveau logique inverse en sortie Q̄. La réception d'une première impulsion d'un train de commande par un circuit de commande d'interface 17 entraîne l'application de cette première impulsion à l'entrée d'horloge H de la bascule 27, via la porte 19, alors que l'entrée RAZ de cette bascule est encore au niveau zéro, ce qui inhibe la bascule et bloque la recopie.

La porte de contrôle 21, de type NAND, est reliée à la sortie de la porte 19 par une première entrée et à la sortie de données Q de la bascule 27 par une seconde entrée, elle attaque la sortie S de l'interface, via un inverseur logique 28. Elle assure donc la transmission des impulsions qu'elle reçoit de la porte 19, sous le contrôle de la bascule 27, à l'exception de la première impulsion de chaque nouveau train reçu par l'interface qui la comporte, puisque cette porte 19 est alors bloquée par la bascule 27, comme indiqué sur les diagrammes D et E de la figure 5 qui représentent respectivement les signaux au niveau de la sortie Q et à celui de la sortie S.

La fin d'un créneau en sortie d'inverseur 26, suite à la fin d'un train d'impulsions, entraîne la remise à zéro de la bascule 27, lorsque le condensateur 20 est déchargé. La bascule 27 commande aussi le générateur de courant 4 de l'interface 3 qui la comporte, ce générateur de courant étant ici constitué au moyen d'un amplificateur de mesure 29 dont l'alimentation négative est commandée par la sortie Q̄ de la bascule 27 via une porte 30, de type NAND.

La porte 30 est reliée par une première entrée à la sortie Q̄ de la bascule 27, par une seconde entrée à l'inverseur 26 et par une troisième entrée à la porte 19. Elle commande donc l'alimentation de l'amplificateur de mesure 29 pendant le palier séparant la première impulsion de train de commande, reçu à l'entrée E de l'interface 3 considérée, de l'impulsion reçue qui la suit, en agissant au niveau de la borne négative d'alimentation de cet amplificateur, comme montré sur le diagramme F de la figure 5.

L'amplificateur de mesure 29 est aussi relié pour son alimentation à la borne "+" de la cellule associée à laquelle est raccordée l'interface 3 qui le comporte. Il a une entrée non-inverseuse reliée au point commun d'un pont diviseur à deux résistances 31, 32 relié entre bornes "-" et "+" de cette cellule associée, de manière à prendre en compte la valeur de la tension présente à ce niveau. Il a aussi une entrée inverseuse reliée, d'une part, par une résistance 33 à cette même borne "+" et, d'autre part à l'émetteur d'un transistor 34, de type PNP, dont le collecteur est relié à la sortie monofilaire M par laquelle l'interface 3 est elle-même reliée à la résistance constituant le transducteur 5 commun à toutes les interfaces de cellule. L'amplificateur de mesure 29 est agencé pour comparer les tensions appliquées à ses deux entrées. Lorsqu'il est alimenté, c'est-à-dire lorsqu'une première impulsion est appliquée à l'interface dans le cadre d'un train de commande TI, il commande en conséquence par sa sortie la base du transistor 34 de manière que celui-ci fournisse à la résistance constituant le transducteur 5 un signal de mesure en courant fonction de la tension fournie à l'interface 3 par la cellule 1 associée, comme montré sur le diagramme G de la figure 5.

Selon une forme de réalisation et comme il est indiqué plus haut, il est possible d'associer un second générateur de courant 6 pour compenser la consommation due au circuit de mesure au niveau d'une cellule, lors des mesures effectuées sur cette cellule par l'intermédiaire de l'interface 3 qui lui est associée.

Dans la variante de réalisation ici envisagée, le second générateur de courant 6 d'une interface 3 comporte essentiellement un amplificateur de compensation 35 qui est commandé en même temps que l'amplificateur de mesure 10 de l'interface 3 qui le comporte et qui est agencé pour fournir à chaque mesure, à la cellule 1 concernée par la mesure et associée à cette interface 3, un courant de compensation correspondant à celui qui est consommé à l'occasion de cette mesure.

A cet effet, l'amplificateur de compensation 35 d'une interface 3 est reliée à la sortie de l'amplificateur de mesure 10, associé à lui dans la même interface, par une entrée inverseuse et via une résistance 36. Il commande par sa sortie la base d'un transistor 37, de type NPN, relié, d'une part, par son émetteur à la résistance constituant l'élément de compensation 7 commun aux interfaces de cellule 3, via la borne C de l'interface le comportant et, d'autre part, par son collecteur à la masse commune, via une résistance 38.

L'amplificateur de compensation 35 d'une interface 3 est alimenté entre la borne "+" de la cellule 1 associée à l'interface et la masse commune, il a une entrée non-inverseuse classiquement relié au point commun aux deux résistances 39 et 40 d'un pont diviseur connecté entre la borne "+" de la cellule associée prise en compte ci-dessus et la masse commune. Il est ainsi possible d'obtenir, au niveau d'une interface 3 et au cours d'une mesure effectuée via cette interface, un courant de compensation fourni par l'amplificateur de compensation 35 qu'elle comporte qui ait même intensité que celui consommé par l'interface pour la mesure et qui soit de polarité opposée comme le montre le diagramme H de la figure 5.

Il apparaît donc un courant de forme impulsionnelle au niveau de la résistance constituant le transducteur commun 5 (figure 1), comme le montre le diagramme I de la figure 5, lorsque les impulsions d'un train de commande TI, sont transmises d'une interface 3 à la suivante et que chaque interface se réserve la première impulsion reçue par elle pour un train de commande afin de créer une impulsion de mesure correspondante au niveau de la résistance constituant le transducteur 5. Ainsi les impulsions successives obtenues pour un même train de commande TI, comme le montre le diagramme I de la figure 5, forment un train TM où les positions temporelles respectives des impulsions correspondent aux positions respectives des interfaces 3, dans l'ordre où celles-ci sont atteintes par les impulsions du train de mesure.

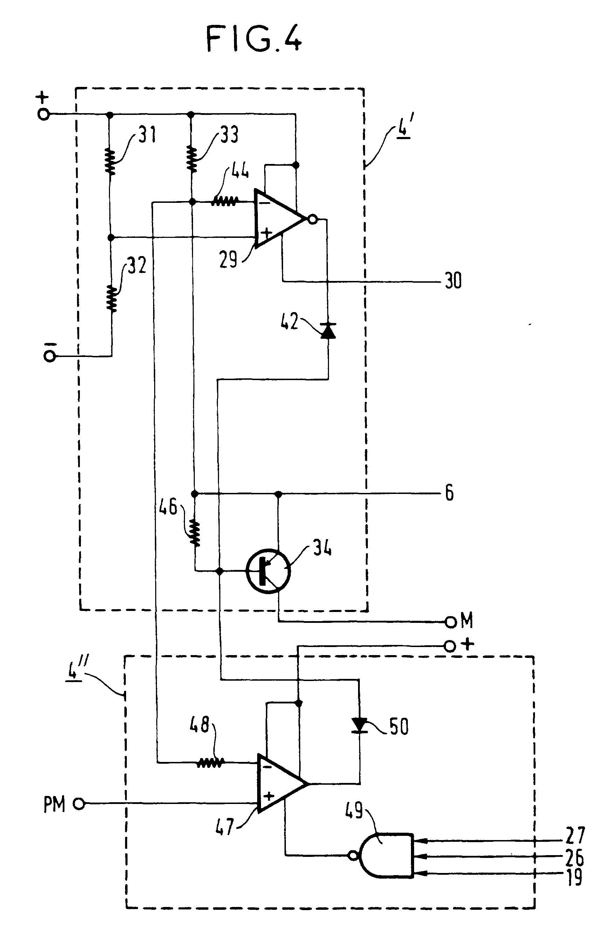

Le diagramme H de la figure 5 illustre qu'à un train TM d'impulsions de mesure correspond un train d'impulsions complémentaires au niveau de l'élément de compensation 7 commune (figure 1), aux fins indiquées plus haut. Il est possible d'envisager de transmettre plus d'une information de mesure à partir d'une même interface 3 de cellule 1, si l'on complète cette interface de la manière proposée sur le schéma complémentaire de la figure 4. A cet effet, il est prévu de substituer un générateur de courant 4' au générateur de courant 4, ce générateur 4' reprenant les éléments constitutifs 29, 31, 32,33 et 34 du précédent et leurs interconnexions respectives aux différences près indiquées ci-dessous.

La sortie de l'amplificateur de mesure 29 est ici reliée à la base du transistor 34 par une diode 42 et une résistance 43 en série, l'entrée inverseuse de cet amplificateur est reliée à une borne de la résistance 33 par une résistance 44 et le point commun à ces deux résistances est relié, d'une part, à la base du transistor 34 par une résistance 45, d'autre part, à une entrée inverseuse d'un amplificateur de mesure 47 par une résistance 48 dans un générateur de courant de mesure supplémentaire 4". L'amplificateur de mesure 47 est ici relié par son entrée non-inverseuse à un point de mesure PM qui permet de prendre en compte une mesure autre que celle réalisée par l'intermédiaire du générateur de courant 4', par exemple une mesure de température au niveau de la cellule 1 associée.

La borne d'alimentation négative de l'amplificateur de mesure 29 reste reliée à la sortie de la porte 30 du circuit de commande 17 de l'interface 3 qui le comporte et l'émetteur du transistor 34 reste, si besoin est, relié à la résistance 36 d'entrée du second générateur de courant 6 de cette interface 3, lorsque ce second générateur existe. L'amplificateur de mesure 47 a sa borne d'alimentation négative commandée au travers d'une porte 49, de type NAND, dont une entrée est reliée à la sortie $\overline{Q}$ de la bascule 27 que contient le circuit de commande 17 considéré ci-dessus. Une seconde et une troisième entrées de cette porte 49 sont respectivement reliées l'une en sortie de l'inverseur 26 et l'autre en sortie de porte 19 de ce même circuit de commande 17. De ce fait l'amplificateur de mesure 47 est commandé par les mêmes signaux que l'amplificateur de mesure 29 avec pour différence une horloge inverse dans la mesure où une mesure y est déclenchée en début d'impulsion de commande, dès que le condensateur 20 correspondant est chargé et pour la durée de l'impulsion, comme indiqué en pointillé sur le diagramme F. L'ajout de la diode 42 reliée par son anode à la base du transistor 34 et d'une diode 50 reliée par son anode à la base du transistor 34 et par sa cathode à la sortie de l'amplificateur de mesure 47 permet en liaison avec l'ajout des résistances 44, 46 et 48 d'exploiter le transistor 34 pour les deux générateurs de courant 4' et 4".

On obtient donc un niveau de courant supplémentaire montré en pointillé sur le diagramme 1G et correspondant à la mesure effectuée par l'intermédiaire du générateur de courant 4" avant celui correspondant à la mesure différente effectuée par l'intermédiaire du générateur de courant 4'. Il est possible de compenser le courant consommé au cours d'une mesure effectuée au niveau d'une interface 3, via le générateur de courant 4", par un courant complémentaire au niveau de cette interface à l'aide du second générateur de courant 6, de même que pour le courant consommé au cours d'une mesure effectuée par l'intermédiaire du générateur de courant 4' au niveau de cette même interface, ceci étant montré sur le diagramme H de la figure 5 où les deux compensations sont montrées l'une en pointillé liée au générateur de courant 4" et l'autre en trait plein liée au générateur de courant 4'.

Le courant de mesure de forme impulsionnelle produit au niveau de la résistance constituant le transducteur commun 5 correspond en conséquence à la somme des deux trains d'impulsions, respectivement dus aux deux circuits de mesure incorporant les générateurs de courant 4' et 4", dont les impulsions s'alternent comme montré sur le diagramme I de la figure 5. Il est donc obtenu un courant de compensation au niveau de l'élément de compensation 7 qui correspond à celui montré sur le diagramme J.

## Revendications

**1.** Circuit de mesure pour ensemble modulaire de cellules (1) électriquement montées en série et constituées chacune d'un ou de plusieurs éléments producteurs, accumulateurs ou convertisseurs d'énergie électrique, notamment d'éléments de batterie d'accumulateur électrique, ledit circuit de mesure comportant des interfaces de mesure individuelles (3) respectivement connectées chacune aux bornes d'énergie ("+" et "-") d'une cellule différente et comportant chacune une sortie de mesure (M) monofilaire pour un signal de mesure en courant destiné à être transmis vers un transducteur commun (5) auquel les sorties de mesure respectives des interfaces sont communément reliées, via une première liaison monofilaire commune, dans le circuit de mesure considéré, chaque interface incorporant au moins un premier générateur de courant (4) pour générer un signal de mesure en courant relatif à une caractéristique évolutive de la cellule correspondante et un circuit de commande (17) pour prendre en compte une des impulsions de commande, qui sont transmises en série dans le cadre d'un train par l'intermédiaire d'une seconde liaison monofilaire (L) afin de commuter successivement passant chacun des générateurs de courant de mesure (4) des interfaces, **caractérisé en ce que** le circuit de commande (17) de chaque interface est agencé pour prendre en compte la première impulsion de commande que l'interface reçoit d'un train, d'un élément de seconde liaison monofilaire, via une première entrée (E), et pour transmettre toute éventuelle impulsion suivante de ce même train, vers l'éventuelle interface située en aval dont la première entrée (E) est alors reliée à sa propre sortie (S) par un autre des éléments successifs constituant la seconde liaison monofilaire (L).

**2.** Circuit de mesure selon la revendication 1, **caractérisé en ce que** chaque interface individuelle (3) incorpore, en premier, un circuit d'entrée (9), à condensateur (11) d'élimination de composante continue, pour recevoir les impulsions de train de commande et, en second, un circuit de commande d'interface (17), relié à la sortie du circuit d'entrée de l'interface et à l'entrée de commande du premier générateur de courant (4) de l'interface considérée, pour commuter passant ce premier générateur de courant à la réception d'une première impulsion de commande et pour transmettre à un éventuel élément de liaison (L) situé en aval, les impulsions qui suivent éventuellement cette première impulsion dans un même train de commande.

**3.** Circuit de mesure selon la revendication 2, **caractérisé en ce que** chaque interface individuelle associée à une cellule est aussi reliée à une borne d'un élément de compensation commun (7), par l'intermédiaire d'un second générateur de courant (6) individuel, situé dans l'interface, commuté passant avec le premier générateur de courant (29) de cette interface et raccordé entre ladite borne d'élément commun et une borne d'énergie (-) de la cellule à laquelle l'interface est associée, pour équilibrer au niveau des différentes cellules de l'ensemble (2) les prélèvements d'énergie déclenchés par un train d'impulsions de commande.

**4.** Circuit de mesure selon la revendication 3, **caractérisé en ce que** chaque interface individuelle comporte un générateur de courant supplémentaire (4") pour traduire sous forme d'un courant une seconde caractéristique évolutive de la cellule à laquelle l'interface considérée est affectée, ce générateur de courant étant relié par la sortie (M) au transducteur commun (5) en parallèle avec le premier générateur de courant (4) de l'interface et commuté alternativement par rapport à lui au cours de la période de train contenant l'impulsion de commande de ce premier générateur.

## Claims

1. Measurement circuit for a modular system of cells (1) electrically connected in series and each constituted by one or more electrical energy producing, accumulating or converting elements, such as electric accumulator battery elements, said circuit comprising individual measurement interfaces (3) each respectively connected to the power terminals ("+" and "-") of a different cell and each including a single-wire measurement output (M) for a current measurement signal to be transmitted to a common transducer (5) to which the respective measurement outputs of the interfaces are connected in common via a first common single-wire connection in the measurement circuit in question, each interface incorporating at least a first current generator (4) for generating a current measurement signal relating to a change in characteristic of the corresponding cell, and a control circuit (17) for responding to one of the control pulses, which are transmitted in series in the context of a stream by means of a second single-wire connection (L) in order to switch each of the interface measuring current generators (4) on in succession, **characterized in that** the control circuit (17) of each interface is adapted to respond to the first command pulse of a stream that the interface receives from a second single-wire connection element via a first input (E) and to transmit any subsequent pulse of the same stream to any interface on its downstream side whose first input (E) is then connected to its own output (S) via another of the successive elements constituting the second single-wire connection (L).

2. Measurement circuit according to claim 1 **characterized in that** each individual interface (3) incorporates an input circuit (9) including a direct current component blocking capacitor (11) for receiving the pulses of said command stream and an interface control circuit (17) connected to the output of the input circuit of the interface and to the control input of the first current generator (4) of the interface in question in order to turn on said first current generator on receiving a first command pulse and to transmit to any connection element (L) on its downstream side any pulses which may follow said first pulse in the same command stream.

3. Measurement circuit according to claim 2 **characterized in that** each individual interface associated with a cell is also connected to a terminal of a common compensator (7) by means of a second individual current generator (6) in the interface turned on with the first current generator (29) of the interface and connected between said common compensator terminal and an energy terminal (-) of the cell with which the interface is associated to balance at the various cells all (2) energy samplings initiated by a command pulse stream.

4. Measurement circuit according to claim 3 **characterized in that** each individual interface includes an additional current generator (4") for converting into the form of a current a second change in characteristic of the cell to which the interface in question is assigned, said current generator being connected by its output (H) to the common transducer (5) in parallel with the first current generator (4) of the interface and switched alternately therewith during the stream containing the command pulse of said first generator.

## Patentansprüche

1. Messschaltung für eine modulare Anordnung von elektrisch in Serie geschalteten Zellen, die jeweils aus einem oder mehreren Erzeuger-, Akkumulator- oder Wandlerelementen für elektrische Energie gebildet sind, insbesondere von Batterieelementen eines elektrischen Akkumulators, wobei die Messschaltung individuelle Messschnittstellen (3) aufweist, die jeweils mit den Energieanschlüssen ("+" und "-") einer anderen Zelle verbunden sind und jeweils einen Ein-Draht-Messausgang (M) für ein Strommesssignal aufweisen, das vorgesehen ist, um an einen gemeinsamen Wandler (5) übertragen zu werden, an den die jeweiligen Messausgänge der Schnittstellen gemeinsam über eine erste gemeinsame Ein-Draht-Verbindung in der betreffenden Messschaltung angeschlossen sind, wobei jede Schnittstelle wenigstens einen ersten Stromgenerator (4) zum Erzeugen eines auf ein veränderliches Merkmal der entsprechenden Zelle bezogenen Strommesssignals und eine Steuerschaltung (17) zum Berücksichtigen eines der Steuerimpulse enthält, die in Serie im Rahmen eines Zuges über eine zweite Ein-Draht-verbindung (L) übertragen werden, um sukzessive jeden der Stromgeneratoren (4) der Schnittstellen durchlässig zu schalten, **dadurch gekennzeichnet, dass** die Steuerschaltung (17) jeder Schnittstelle eingerichtet ist, um den ersten Steuerimpuls eines Zuges, den die Schnittstelle von einem Element der zweiten Ein-Draht-Verbindung über einen ersten Eingang (E) empfängt, zu berücksichtigen und jeden eventuellen folgenden Impuls des gleichen Zuges an eine eventuelle nachgeordnete Schnittstelle zu übertragen, deren erster Eingang (E) dann mit ihrem eigenen Ausgang (S) über ein anderes der aufeinanderfolgenden Elemente verbunden ist, die die zweite Ein-Draht-Verbindung (L) bilden.

2. Messschaltung nach Anspruch 1, **dadurch gekennzeichnet, dass** jede einzelne Schnittstelle (3) erstens eine Eingangsschaltung (9) mit einem Kondensator (11) zum Unterdrükken einer Gleichspannungskomponente, um die Impulse des Steuerzuges zu empfangen, und zweitens eine Schnittstellensteuerschaltung (17) enthält, die mit dem Ausgang der Schnittstelleneingangsschaltung und dem Steuereingang des ersten Stromgenerators (4) der betreffenden Schnittstelle verbunden ist, um diesen ersten Stromgenerator bei Empfang eines ersten Steuerimpulses durchlässig zu schalten und um an ein eventuelles nachgeordnetes Verbindungselement (L) die Impulse zu übertragen, die eventuell auf diesen ersten Impuls in einem gleichen Steuerzug folgen.

3. Messschaltung nach Anspruch 2, **dadurch gekennzeichnet, dass** jede einzelne einer Zelle zugeordnete Schnittstelle auch mit einem Anschluss eines gemeinsamen Kompensationselements (7) über einen zweiten einzelnen Stromgenerator (6) verbunden ist, der sich in der Schnittstelle befindet und mit dem ersten Stromgenerator (29) dieser Schnittstelle durchlässig geschaltet wird und zwischen dem Anschluss des gemeinsamen Elements und einem Energieanschluss (-) der Zelle verbunden ist, der diese Schnittstelle zugeordnet ist, um auf dem Niveau der verschiedenen Zellen der Anordnung (2) die von einem Steuerimpulszug ausgelösten Entnahmen von Energie auszugleichen.

4. Messschaltung nach Anspruch 3, **dadurch gekennzeichnet, dass** jede einzelne Schnittstelle einen zusätzlichen Stromgenerator (4") zum Umsetzen eines zweiten veränderlichen Merkmals der Zelle, der die betreffende Schnittstelle zugeordnet ist, in die Form eines Stroms umfasst, wobei dieser Stromgenerator über den Ausgang (M) mit dem gemeinsamen Wandler (5) parallel zum ersten Stromgenerator (4) der Schnittstelle verbunden ist und alternativ zu diesem im Laufe der Periode des Zuges geschaltet wird, der den Steuerimpuls dieses ersten Generators enthält.

# FIG.1

FIG.2

FIG.3

# FIG.4

# FIG.5